(19) Europäisches Patentamt
European Patent Office
Office européen des brevets

(11) **EP 4 648 091 A1**

(12) **EUROPEAN PATENT APPLICATION**

(43) Date of publication:
**12.11.2025 Bulletin 2025/46**

(21) Application number: **25173188.1**

(22) Date of filing: **29.04.2025**

(51) International Patent Classification (IPC):
***H01L 21/677*** (2006.01)   ***H01L 21/67*** (2006.01)
***G01B 21/22*** (2006.01)   ***G01C 9/02*** (2006.01)

(52) Cooperative Patent Classification (CPC):
**H01L 21/67766; G01B 21/22; G01C 9/02;**
**H01L 21/67265; H01L 21/67787**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **07.05.2024 TW 113116764**

(71) Applicant: **Wistron NeWeb Corporation**
**Hsinchu 30844 (TW)**

(72) Inventors:
• **WU, Chia-Hsin**
 **30844 HSINCHU (TW)**

• **KANG, Fu-Ming**
 **30844 HSINCHU (TW)**
• **CHEN, Ting-Huei**
 **30844 HSINCHU (TW)**
• **TSO, Ko-Wen**
 **30844 HSINCHU (TW)**
• **IP, Sin Sze**
 **30844 HSINCHU (TW)**

(74) Representative: **Viering, Jentschura & Partner**
**mbB**
**Patent- und Rechtsanwälte**
**Am Brauhaus 8**
**01099 Dresden (DE)**

(54) **DETECTION SYSTEM, DETECTION METHOD AND DETECTION DEVICE FOR OBJECT PLACEMENT STATUS**

(57) A detection system, a detection method and a detection device for object placement status are provided, and the detection system includes a test object (1), a three-axis acceleration sensor (2), and a controller (5). The three-axis acceleration sensor (2) is disposed on the test object (1) and detects a three-axis acceleration of the test object (1). The controller (5) calculates a current tilt angle based on the three-axis acceleration of the test object (1). The controller (5) calculates an angle difference between the current tilt angle and a reference tilt angle of the test object (1) and determines whether the angle difference exceeds an angle threshold. When the controller (5) determines that the angle difference exceeds the angle threshold, the controller (5) triggers an alarm signal.

FIG. 2

EP 4 648 091 A1

## Description

### FIELD OF THE INVENTION

The present invention relates the field of object transportation, and more particularly, to a system, a method, and a device for detecting the placement status of an object during a transfer process.

### BACKGROUND OF THE INVENTION

In the process of wafer manufacturing, it is often necessary to use robotic arms to remove wafers from wafer slots in wafer boxes or place wafers into wafer slots in wafer boxes. Whether it be removing wafers from wafer slots or placing wafers into wafer slots, the relative angle between the wafer and the wafer slot or the carrying tray of the robotic arm should not be excessively tilted. Otherwise, during the transfer process, the robotic arm may cause scratches on the wafer, or in severe cases, break the wafer. The broken wafer fragments may contaminate other wafers placed in the wafer box.

Currently, wafer inspection is performed by inspection personnel who visually check if the wafers placed in the wafer box are excessively tilted and if there are any wafer fragments or stacked wafers. However, manual inspection is time-consuming and prone to missed or incorrect inspections.

### SUMMARY OF THE INVENTION

In one aspect, the present invention provides a detection system for object placement status, which includes a test object, a three-axis acceleration sensor, and a controller. The three-axis acceleration sensor is disposed on the test object for detecting the three-axis acceleration of the test object. The controller calculates a current tilt angle of the test object based on the three-axis acceleration. The controller calculates an angle difference between the current tilt angle and a reference tilt angle of the test object and determines whether the angle difference exceeds an angle threshold. When the controller determines that the angle difference exceeds the angle threshold, the controller triggers an alarm signal.

In another aspect, the present invention provides a detection method for object placement status, which includes the following steps: providing a test object, wherein a three-axis acceleration sensor is disposed on the test object; detecting a three-axis acceleration of the test object through the three-axis acceleration sensor; calculating a current tilt angle of the test object based on the three-axis acceleration through a controller; calculating an angle difference between the current tilt angle and a reference tilt angle of the test object through the controller; determining, by the controller, whether the angle difference exceeds the angle threshold; and triggering an alarm signal by the controller when the controller determines that the angle difference exceeds the angle threshold.

In yet another aspect, the present invention provides a detection device for object placement status, which includes a test object and a three-axis acceleration sensor. The three-axis acceleration sensor is disposed on the test object for detecting a three-axis acceleration of the test object. When the test object is at a reference position at a first time point, the three-axis acceleration detected by the three-axis acceleration sensor is defined as a reference three-axis acceleration of the test object. After the first time point, the three-axis acceleration detected by the three-axis acceleration sensor is defined as a current three-axis acceleration of the test object.

These and other aspects of the present invention will become apparent from the following description of the embodiment taken in conjunction with the following drawings and their captions, although variations and modifications therein may be affected without departing from the spirit and scope of the novel concepts of the invention.

### BRIEF DESCRIPTION OF THE DRAWINGS

The described embodiments may be better understood by reference to the following description and the accompanying drawings, in which:

FIG. 1 is a schematic diagram of an embodiment of a detection device for object placement status according to the present invention.
FIG. 2 is a schematic diagram of an embodiment of a detection system for object placement status according to the present invention.
FIG. 3 is a schematic diagram of an embodiment of the detection system for object placement status applied to semiconductor processes according to the present invention.
FIG. 4 is a schematic diagram of an embodiment of setting a reference position of a test wafer according to the present invention.
FIG. 5 is a flowchart of a calibration procedure for a test wafer.
FIG. 6 is a schematic diagram of a first embodiment of a detection method for object placement status according to the present invention.
FIG. 7 is a schematic diagram of a second embodiment of the detection method for object placement status according to the present invention.
FIG. 8 is a schematic diagram of a third embodiment of the detection method for object placement status according to the present invention.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a", "an", and "the" includes plural reference, and the meaning of "in" includes "in" and "on". Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first", "second" or "third" can be used to describe various components, signals or the like, which are for distinguishing one component/signal from another one only, and are not intended to, nor should be construed to impose any substantive limitations on the components, signals or the like.

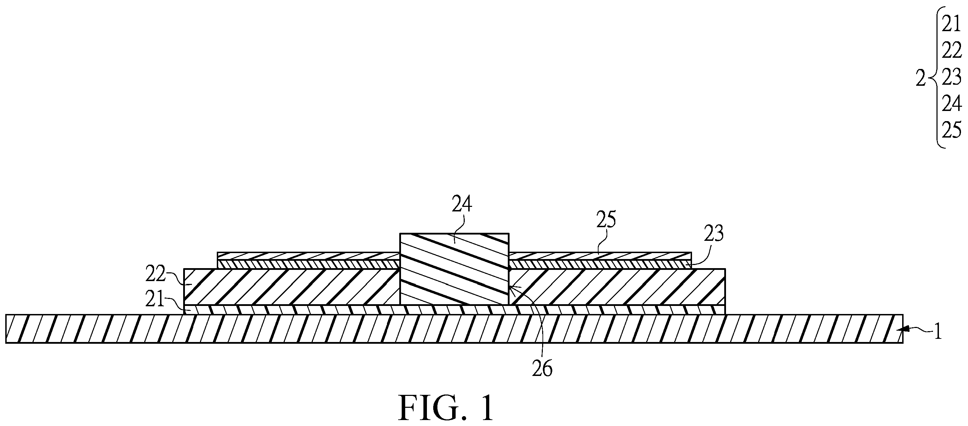

FIG. 1 is a schematic diagram of an embodiment of a detection device for object placement status according to the present invention. Referring to FIG. 1, the detection device includes a test object 1 and a three-axis acceleration sensor 2. The test object 1 is a substitute for various products to be processed, such as circuit boards, wafers, electronic components, or mechanical components. The test object 1 is used to simulate the situations that the products to be processed may encounter during the processing procedures in advance. The three-axis acceleration sensor 2 is disposed on the test object 1 to detect the three-axis acceleration of the test object 1.

The three-axis acceleration sensor 2 includes a ground layer 21, a transparent material layer 22, a conductive layer 23, a sensing substrate 24, and a first antenna 25. The bottom of the ground layer 21 is connected to the test object 1. The transparent material layer 22 is, for example, Poly Methyl Methacrylate (PMMA) or Polycarbonate (PC), and is connected to the top of the ground layer 21. The conductive layer 23 is, for example, Aluminum Matrix Composite (AMC), and is connected to the top of the transparent material layer 22.

The ground layer 21, transparent material layer 22, and conductive layer 23 form a stacked structure, and the stacked structure has a slot 26 penetrating through the ground layer 21, transparent material layer 22, and conductive layer 23. The sensing substrate 24 includes a printed circuit board and an acceleration sensing chip disposed on the printed circuit board, and the sensing substrate 24 is disposed in the slot 26. The first antenna 25 is disposed on the conductive layer 23 and connected to the sensing substrate 24.

When the test object 1 is at a reference position at a first time point, the three-axis acceleration detected by the three-axis acceleration sensor 2 is defined as the reference three-axis acceleration of the test object 1. After the first time point, the three-axis acceleration detected by the three-axis acceleration sensor 2 is defined as the current three-axis acceleration of the test object 1. For example, when the product to be processed undergoes processing procedures, it will sequentially pass through multiple different processing stations. When the test object 1 is at the first processing station, the first processing station is defined as the reference position of the test object 1.

For example, the test object 1 is a test wafer, and the test wafer is used to simulate the actual situations that occur in the wafer factory in advance. This allows inspection personnel to adjust the parameter settings of various semiconductor machines in the wafer factory in advance to ensure the safety of the wafer during handling or transfer process. When the test wafer is placed in the lowest wafer slot in the wafer box, the lowest wafer slot in the wafer box is defined as the reference position of the test wafer.

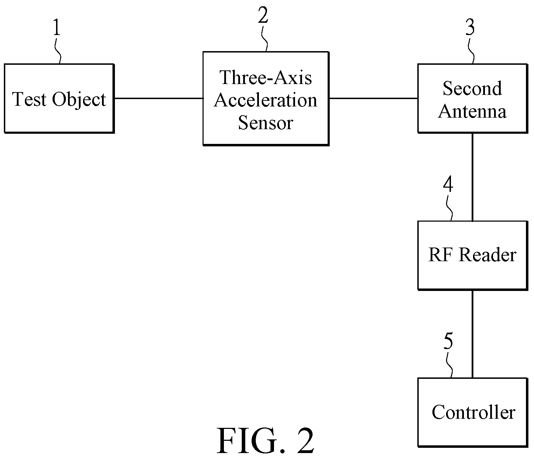

FIG. 2 is a schematic diagram of an embodiment of a detection system for object placement status according to the present invention. Referring to FIG. 2, the detection system includes a test object 1, a three-axis acceleration sensor 2, a second antenna 3, an RF (Radio Frequency) reader 4, and a controller 5. The three-axis acceleration sensor 2 is disposed on the test object 1 to detect the three-axis acceleration of the test object 1. The three-axis acceleration includes X-axis acceleration, Y-axis acceleration, and Z-axis acceleration.

The three-axis acceleration sensor 2 includes a ground layer 21, a transparent material layer 22, a conductive layer 23, a sensing substrate 24, and a first antenna 25. The first antenna 25 sends RF signals to the second antenna 3 or receives RF signals from the second antenna 3. The second antenna 3 sends RF signals to the first antenna 25 or receives RF signals from the first antenna 25. The RF reader 4 is electrically connected to the second antenna 3 and the controller 5. When the first antenna 25 sends RF signals to the second antenna 3, the RF signals contain information about the three-axis acceleration of the test object 1. When the second antenna 3 receives RF signals from the first antenna 25, the RF reader 4 reads the information about the three-axis acceleration of the test object 1 from the RF signals and sends the information to the controller 5. The memory of the controller 5 stores conversion formulae, and the controller 5 can convert the three-axis acceleration into a tilt angle based on the conversion formulae:

$$a=\sqrt{ax^2 + ay^2 + az^2}$$

, where ax is the X-axis acceleration, ay is the Y-axis acceleration, and az is the Z-axis acceleration.

$\theta=\cos^{-1}(a/g)$, where $\theta$ is the tilt angle, and g is the gravitational acceleration.

The detection system also includes a first transfer box, and a moving device can transfer the test object 1 to a first receiving slot in the first transfer box, which is defined as the reference position of the test object 1. When the test object 1 is placed in the first receiving slot of the first transfer box, the controller 5 calculates the reference tilt angle of the test object 1 based on the three-axis acceleration detected by the three-axis acceleration sensor 2.

Next, the moving device can transfer the test object 1 from the first receiving slot of the first transfer box to a second receiving slot in the first transfer box or to a third receiving slot in a second transfer box. When the test object 1 is moved to the second receiving slot in the first transfer box or the third receiving slot in the second transfer box, the second receiving slot or the third receiving slot is defined as the current position of the test object 1. The controller 5 calculates the current tilt angle of the test object 1 based on the three-axis acceleration detected by the three-axis acceleration sensor 2.

Specifically, the first receiving slot in the first transfer box is defined as the reference position of the test object 1, and the three-axis acceleration of the test object 1 at the reference position is defined as the reference three-axis acceleration of the test object 1.

The controller 5 calculates the tilt angle of the test object 1 based on the reference three-axis acceleration of the test object 1. The tilt angle of the test object 1 at the reference position is defined as the reference tilt angle of the test object 1, and the memory of the controller 5 is used to store the reference tilt angle of the test object 1.

After the controller 5 stores the reference tilt angle of the test object 1, the three-axis acceleration sensor 2 continuously detects the three-axis acceleration of the test object 1. At this time, the three-axis acceleration detected by the three-axis acceleration sensor 2 is defined as the current three-axis acceleration of the test object 1. The controller 5 calculates the current tilt angle of the test object 1 based on the current three-axis acceleration of the test object 1, and the current tilt angle of the test object 1 is stored in the memory of the controller 5.

When the test object 1 is in an abnormal state, the controller 5 triggers an alarm signal. The following lists several different scenarios in which the controller 5 triggers an alarm signal.

For example, in the first scenario, after the controller 5 obtains the reference tilt angle and the current tilt angle of the test object 1, the controller 5 calculates the angle difference between the current tilt angle and the reference tilt angle of the test object 1. The memory of the controller 5 stores an angle threshold, and the controller 5 determines whether the angle difference exceeds the angle threshold. When the controller 5 determines that the angle difference exceeds the angle threshold, it indicates that the tilt angle of the test object 1 does not meet the safety regulations, and the controller 5 triggers an alarm signal.

For example, in the second scenario, the memory of the controller 5 stores an acceleration threshold. After the controller 5 obtains the reference tilt angle of the test object 1, the controller 5 again obtains the three-axis acceleration of the test object 1. The controller 5 determines whether the X-axis acceleration, Y-axis acceleration, or Z-axis acceleration of the test object 1 exceeds the acceleration threshold. When the controller 5 determines that the X-axis acceleration, Y-axis acceleration, or Z-axis acceleration of the test object 1 exceeds the acceleration threshold, it indicates that the horizontal or vertical acceleration of the test object 1 does not meet the safety regulations, and the controller 5 triggers an alarm signal.

For example, in the third scenario, after the controller 5 obtains the reference tilt angle of the test object 1, the controller 5 again obtains the three-axis acceleration of the test object 1. The controller 5 determines whether the X-axis acceleration and Y-axis acceleration of the test object 1 are both zero. When the controller 5 determines that the X-axis acceleration and Y-axis acceleration of the test object 1 are both zero, the controller 5 determines whether the Z-axis acceleration of the test object 1 exceeds the acceleration threshold. When the controller 5 determines that the Z-axis acceleration of the test object 1 exceeds the acceleration threshold, it indicates that the vertical acceleration of the test object 1 does not meet the safety regulations, and the controller 5 triggers an alarm signal.

When the detection system for object placement status is applied to semiconductor processes, the test object 1 is a test wafer, the first transfer box is a first wafer box, the second transfer box is a second wafer box, the first receiving slot is a first wafer slot in the first wafer box, the second receiving slot is a second wafer slot in the first wafer box, and the third receiving slot is a third wafer slot in the second wafer box.

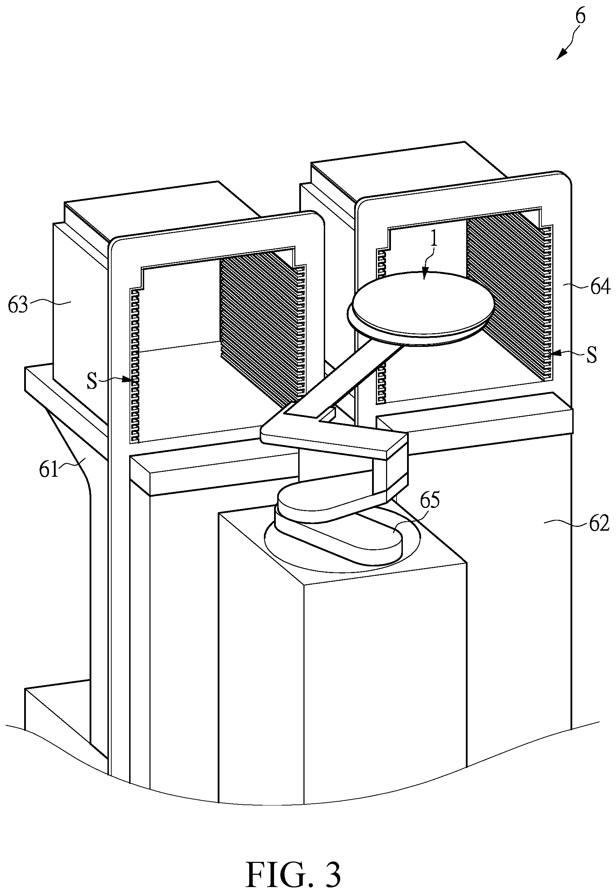

FIG. 3 is a schematic diagram of an embodiment of the detection system for object placement status applied to semiconductor processes according to the present invention. Referring to FIG. 3, a cleanroom 6 is equipped with a first load port unit (LPU) 61, a second load port unit 62, a first wafer box 63, a second wafer box 64, and a robotic arm 65. Each of the first wafer box 63 and the second wafer box 64 is equipped with multiple wafer slots S. The first wafer box 63 is placed on the first load port unit 61, and the second wafer box 64 is placed on the second load port unit 62. The test object 1 is a test wafer, and the test wafer is placed on the robotic arm 65. The robotic arm 65 places the test wafer into any wafer slot S in the first wafer box 63 or the second wafer box 64. The three-axis acceleration sensor 2 on the test wafer detects the three-axis acceleration of the test wafer, and the controller 5 determines whether the status of the test wafer meets the safety regulations based on the three-axis acceleration of the test wafer. When the status of the test wafer does not meet the safety regulations, the controller 5 triggers an alarm signal to notify the inspection personnel, allowing the inspection personnel to adjust the parameter settings of the first load port unit 61, the second load port unit 62, and the robotic arm 65 in advance to ensure the safety of the actual wafers during transfer process in the cleanroom 6.

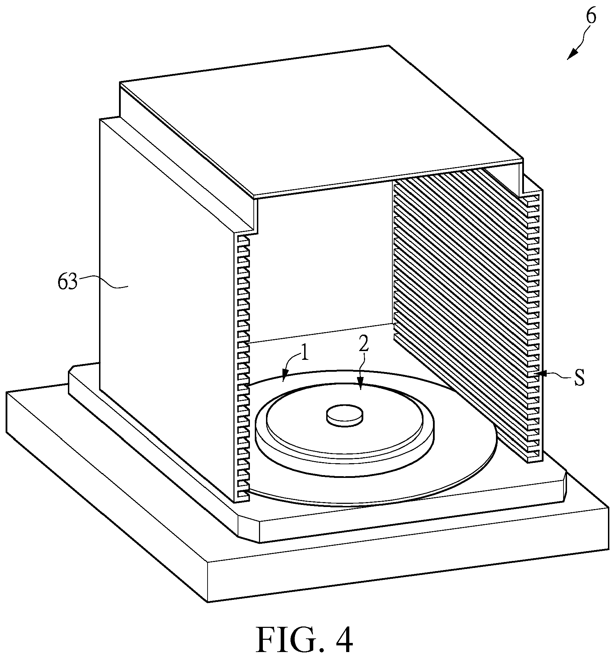

FIG. 4 is a schematic diagram of an embodiment of setting the reference position of the test wafer according to the present invention. As shown in FIG. 4, the test object 1 is a test wafer, and the three-axis acceleration sensor 2 is disposed on the test object 1. When the robotic arm 65 places the test wafer in the lowest wafer slot S (the first wafer slot) in the first wafer box 63, the lowest wafer slot S in the first wafer box 63 is defined as the reference position of the test wafer by the controller 5. In other embodiments, the controller 5 can also define other wafer slots S in the first wafer box 63 as the reference position of the test wafer. For example, the controller 5 can define the highest wafer slot S (the second wafer slot) in the first wafer box 63 as the reference position of the test wafer.

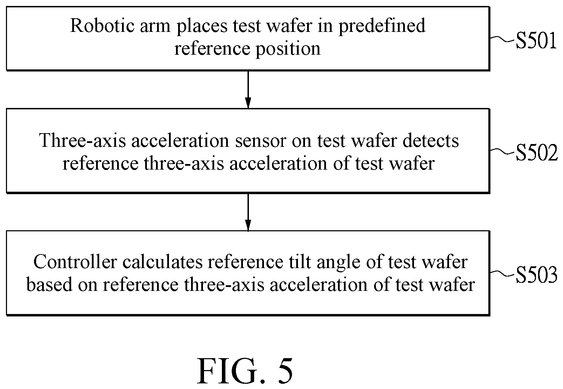

FIG. 5 is a flowchart of the calibration procedure for the test wafer. Referring to FIG. 5, in step S501, the robotic arm 65 places the test wafer in the reference position predefined by the controller 5. In step S502, the three-axis acceleration sensor 2 on the test wafer detects the reference three-axis acceleration of the test wafer. In step S503, the controller 5 calculates the reference tilt angle of the test wafer based on the reference three-axis acceleration of the test wafer.

After completing the calibration procedure for the test wafer, the detection method for object placement status of the present invention is used to determine whether the state of the test wafer complies with safety regulations. The following will enumerate several embodiments of the detection method for object placement status.

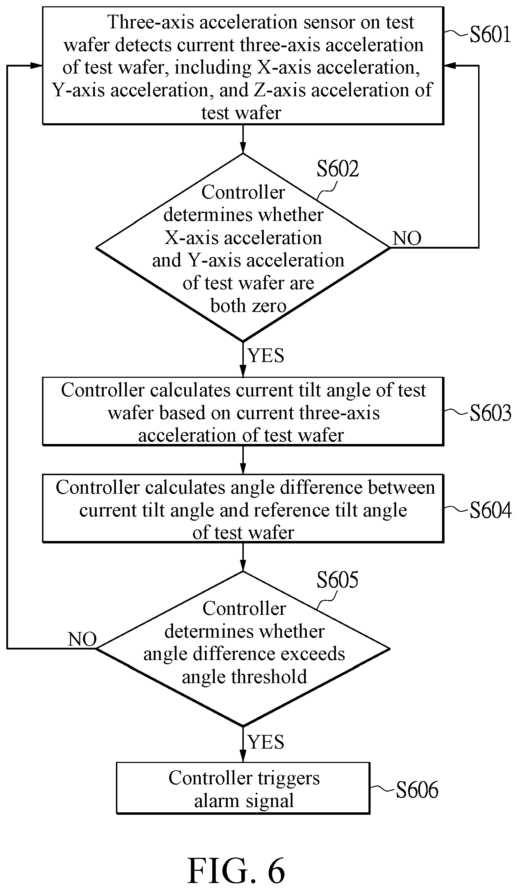

FIG. 6 is a schematic diagram of a first embodiment of the detection method for object placement status according to the present invention. In step S601, the three-axis acceleration sensor 2 on the test wafer detects the current three-axis acceleration of the test wafer, including the X-axis acceleration, Y-axis acceleration, and Z-axis acceleration of the test wafer. In step S602, the controller 5 determines whether the X-axis acceleration and Y-axis acceleration of the test wafer are both zero. If so, proceed to step S603. If not, return to step S601.

Specifically, when the X-axis acceleration and Y-axis acceleration of the test wafer are both zero, it may be that the robotic arm 65 has placed the test wafer in the wafer slot, or the robotic arm 65 has moved the test wafer into the wafer box, but the test wafer is still on the robotic arm 65 and has not fallen into the wafer slot.

In step S603, the controller 5 calculates the current tilt angle of the test wafer based on the current three-axis acceleration of the test wafer. In step S604, the controller 5 calculates the angle difference between the current tilt angle and the reference tilt angle of the test wafer. In step S605, the controller 5 determines whether the angle difference exceeds the angle threshold. If so, proceed to step S606. If not, return to step S601.

In step S606, the controller 5 triggers an alarm signal.

For example, the robotic arm 65 has placed the test wafer in the wafer slot of the wafer box, and if the controller 5 determines that the angle difference between the current tilt angle and the reference tilt angle of the test wafer exceeds the angle threshold, the controller 5 triggers an alarm signal.

For example, the robotic arm 65 has moved the test wafer into the wafer box but the test wafer is still on the robotic arm 65, and if the controller 5 determines that the angle difference between the current tilt angle and the reference tilt angle of the test wafer exceeds the angle threshold, the controller 5 triggers an alarm signal.

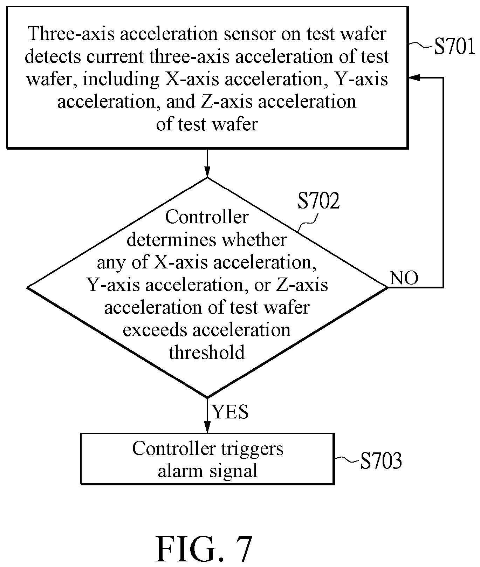

FIG. 7 is a schematic diagram of a third embodiment of the detection method for object placement status according to the present invention. Referring to FIG. 7, in step S701, the three-axis acceleration sensor 2 on the test wafer detects the current three-axis acceleration of the test wafer, including the X-axis acceleration, Y-axis acceleration, and Z-axis acceleration of the test wafer. In step S702, the controller 5 determines whether any one of the X-axis acceleration, the Y-axis acceleration, and the Z-axis acceleration of the test wafer exceeds the acceleration threshold. If so, proceed to step S703. If not, return to step S701. In step S703, the controller 5 triggers an alarm signal.

For example, the test wafer is on the robotic arm 65 and the robotic arm 6 is moving towards the wafer box, and if the three-axis acceleration sensor 2 detects that any one of the X-axis acceleration, the Y-axis acceleration, and the Z-axis acceleration of the test wafer exceeds the acceleration threshold, the controller 5 triggers an alarm signal.

For example, the test wafer is on the robotic arm 65 and the robotic arm 65 is moving away from the wafer box, and if the three-axis acceleration sensor 2 detects that any one of the X-axis acceleration, the Y-axis acceleration, and the Z-axis acceleration of the test wafer exceeds the acceleration threshold, the controller 5 triggers an alarm signal.

For example, the test wafer is dropping from the robotic arm 65 into the wafer slot of the wafer box, and if the three-axis acceleration sensor 2 detects that any one of the X-axis acceleration, the Y-axis acceleration, and the Z-axis acceleration of the test wafer exceeds the acceleration threshold, the controller 5 triggers an alarm signal.

For example, the test wafer has been placed in the wafer slot of the wafer box by the robotic arm 65, and if the three-axis acceleration sensor 2 detects that any one of the X-axis acceleration, the Y-axis acceleration, and the Z-axis acceleration of the test wafer exceeds the acceleration threshold, the controller 5 triggers an alarm signal.

For example, the test wafer has been moved into the wafer box by the robotic arm 65 but is still on the robotic arm 65 and has not dropped into the wafer slot, and if the three-axis acceleration sensor 2 detects that any one of the X-axis acceleration, the Y-axis acceleration, and the Z-axis acceleration of the test wafer exceeds the acceleration threshold, the controller 5 triggers an alarm signal.

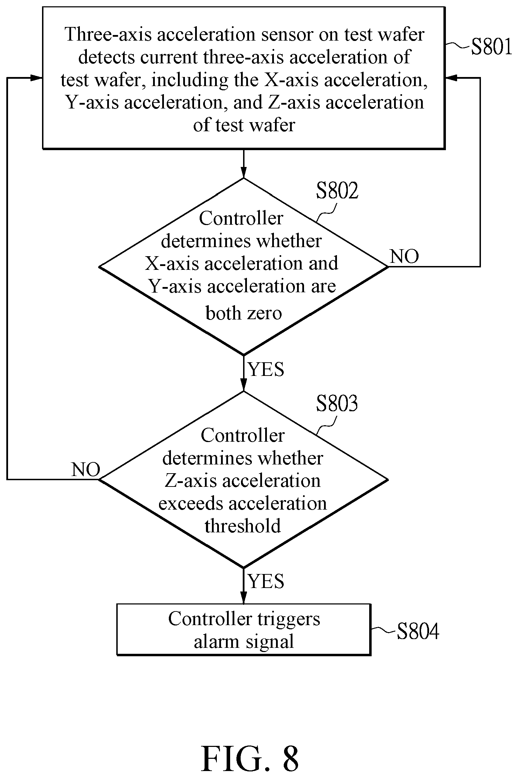

FIG. 8 is a schematic diagram of a fourth embodiment of the detection method for object placement status according to the present invention. Referring to FIG. 8, in step S801, the three-axis acceleration sensor 2 on the test wafer detects the current three-axis acceleration of the test wafer, including the X-axis acceleration, Y-axis acceleration, and Z-axis acceleration of the test wafer. In step S802, the controller 5 determines whether the X-axis acceleration and Y-axis acceleration are both zero. If so, proceed to step S803. If not, return to step S801.

In step S803, the controller 5 determines whether the Z-axis acceleration exceeds the acceleration threshold. If so, proceed to step S804. If not, return to step S801. In step S804, the controller 5 triggers an alarm signal.

For example, the test wafer is dropping from the robotic arm 65 into the wafer slot of the wafer box, and if the three-axis acceleration sensor 2 detects that the Z-axis acceleration exceeds the acceleration threshold, the controller 5 triggers an alarm signal.

[Beneficial Effects of the Embodiments]

One of the beneficial effects of the present invention is that the detection system, method, and device for object placement status provided by the present invention automatically trigger an alarm signal to the inspection personnel whenever an abnormal placement status of the test object is detected, allowing the inspection personnel to quickly resolve the abnormal situation. This saves inspection time and reduces the probability of missed and incorrect inspections.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

**Claims**

1. A detection system for object placement status, **characterized by** comprising:

   a test object (1);
   a three-axis acceleration sensor (2), disposed on the test object (1) for detecting a three-axis acceleration of the test object (1), the three-axis acceleration comprising an X-axis acceleration, a Y-axis acceleration, and a Z-axis acceleration; and
   a controller (5), for calculating a current tilt angle of the test object (1) based on the three-axis acceleration, calculating an angle difference between the current tilt angle and a reference tilt angle of the test object (1), and determining whether the angle difference exceeds an angle threshold;
   wherein, when the controller (5) determines that the angle difference exceeds the angle threshold, the controller (5) triggers an alarm signal.

2. The detection system as claimed in claim 1, wherein, when the test object (1) is at a reference position at a first time point, the controller (5) calculates the reference tilt angle of the test object (1) based on the three-axis acceleration detected by the three-axis acceleration sensor (2); wherein, after the first time point, the controller (5) calculates the current tilt angle of the test object (1) based on the three-axis acceleration detected by the three-axis acceleration sensor (2).

3. The detection system as claimed in claim 1, wherein the controller (5) is configured to determine whether any one of the X-axis acceleration, the Y-axis acceleration, and the Z-axis acceleration exceeds an acceleration threshold, and when any one of the X-axis acceleration, the Y-axis acceleration, and the Z-axis acceleration exceeds the acceleration threshold, the controller (5) triggers the alarm signal.

4. The detection system as claimed in claim 1, wherein the controller (5) is configured to determine whether the X-axis acceleration and the Y-axis acceleration are both zero; wherein, when the X-axis acceleration and the Y-axis acceleration are both zero, the controller (5) is configured to determine whether the Z-axis acceleration exceeds an acceleration threshold, and when the Z-axis acceleration exceeds the acceleration threshold, the controller (5) triggers the alarm signal.

5. The detection system as claimed in claim 1, wherein the three-axis acceleration sensor (2) comprises a sensing substrate (24) and a first antenna (25), the sensing substrate (24) is connected to the first antenna (25), the detection system further comprises a second antenna (3) and an RF reader (4), the first antenna (25) is communicatively connected to the second antenna (3), and the RF reader (4) is electrically connected to the second antenna (3) and the controller (5).

6. The detection system as claimed in claim 1, further comprising a first transfer box, wherein, when the test object (1) is moved to a first receiving slot in the first transfer box, the controller (5) calculates the reference tilt angle based on the three-axis acceleration detected by the three-axis acceleration sensor (2); wherein, when the test object (1) is moved from the first receiving slot to a second receiving slot in the first transfer box or to a third receiving slot in a second transfer box, the controller (5) calculates the current tilt angle based on the three-axis acceleration detected by the three-axis acceleration sensor (2).

7. The detection system as claimed in claim 6, wherein the test object (1) is a test wafer, the first transfer box is a first wafer box (63), the first receiving slot is a first wafer slot in the first wafer box (63), the second receiving slot is a second wafer slot in the first wafer box (63), the second transfer box is a second wafer box (64), and the third receiving slot is a third wafer slot in the second wafer box (64).

8. The detection system as claimed in claim 1, wherein the controller (5) is configured to determine whether the X-axis acceleration and the Y-axis acceleration are both zero; wherein, when the X-axis acceleration and the Y-axis acceleration are both zero, the controller (5) calculates the current tilt angle.

9. A detection method for object placement status, **characterized by** comprising:

   providing a test object (1), wherein a three-axis acceleration sensor (2) is disposed on the test object (1);
   detecting a three-axis acceleration of the test object (1) through the three-axis acceleration sensor (2), the three-axis acceleration comprising an X-axis acceleration, a Y-axis acceleration, and a Z-axis acceleration;
   calculating a current tilt angle of the test object (1) based on the three-axis acceleration through a controller (5);
   calculating an angle difference between the current tilt angle and a reference tilt angle of the test object (1) through the controller (5);

   determining, by the controller (5), whether the angle difference exceeds an angle threshold; and
   triggering an alarm signal by the controller (5) when the controller (5) determines that the angle difference exceeds the angle threshold.

10. The detection method as claimed in claim 9, wherein, when the test object (1) is at a reference position at a first time point, the controller (5) calculates the reference tilt angle based on the three-axis acceleration detected by the three-axis acceleration sensor (2); wherein, after the first time point, the controller (5) calculates the current tilt angle based on the three-axis acceleration detected by the three-axis acceleration sensor (2).

11. The detection method as claimed in claim 9, further comprising:

    determining, by the controller (5), whether the X-axis acceleration and the Y-axis acceleration are both zero; and
    calculating the current tilt angle by the controller (5) when the X-axis acceleration and the Y-axis acceleration are both zero.

12. The detection method as claimed in claim 9, further comprising:

    determining, by the controller (5), whether any one of the X-axis acceleration, the Y-axis acceleration, and the Z-axis acceleration exceeds an acceleration threshold; and
    generating the alarm signal by the controller (5) when any one of the X-axis acceleration, the Y-axis acceleration, and the Z-axis acceleration exceeds the acceleration threshold.

13. The detection method as claimed in claim 9, further comprising:

    determining, by the controller (5), whether the X-axis acceleration and the Y-axis acceleration are both zero;
    when the X-axis acceleration and the Y-axis acceleration are both zero, determining, by the controller (5), whether the Z-axis acceleration exceeds an acceleration threshold; and
    triggering the alarm signal by the controller (5) when the Z-axis acceleration exceeds the acceleration threshold.

14. The detection method as claimed in claim 9, further comprising:

    moving the test object (1) to a first receiving slot in a first transfer box through a moving device;

and

calculating the reference tilt angle by the controller (5) based on the three-axis acceleration that is detected by the three-axis acceleration sensor (2).

15. The detection method as claimed in claim 14, further comprising:

moving the test object (1) from the first receiving slot to a second receiving slot in the first transfer box or to a third receiving slot in a second transfer box through the moving device; and calculating the current tilt angle by the controller (5) based on the three-axis acceleration that is detected by the three-axis acceleration sensor (2).

16. The detection method as claimed in claim 15, wherein the test object (1) is a test wafer, the first transfer box is a first wafer box (63), the second transfer box is a second wafer box (64), the first receiving slot is a first wafer slot in the first wafer box (63), the second receiving slot is a second wafer slot in the first wafer box (63), and the third receiving slot is a third wafer slot in the second wafer box (64).

17. A detection device for object placement status, **characterized by** comprising:

a test object (1); and
a three-axis acceleration sensor (2), disposed on the test object (1) for detecting a three-axis acceleration of the test object (1);
wherein, when the test object (1) is at a reference position at a first time point, the three-axis acceleration detected by the three-axis acceleration sensor (2) is defined as a reference three-axis acceleration of the test object (1);
wherein, after the first time point, the three-axis acceleration detected by the three-axis acceleration sensor (2) is defined as a current three-axis acceleration of the test object (1).

18. The detection device as claimed in claim 17, wherein the three-axis acceleration sensor (2) comprises a sensing substrate (24) and a first antenna (25), and the sensing substrate (24) is connected to the first antenna (25).

19. The detection device as claimed in claim 17, wherein the test object (1) is a test wafer, and the reference position is a wafer slot in a wafer box.

FIG. 1

Test Object `1`

Three-Axis Acceleration Sensor `2`

Second Antenna `3`

RF Reader `4`

Controller `5`

FIG. 2

FIG. 3

EP 4 648 091 A1

**FIG. 4**

Robotic arm places test wafer in predefined reference position — S501

Three-axis acceleration sensor on test wafer detects reference three-axis acceleration of test wafer — S502

Controller calculates reference tilt angle of test wafer based on reference three-axis acceleration of test wafer — S503

# FIG. 5

Three-axis acceleration sensor on test wafer detects current three-axis acceleration of test wafer, including X-axis acceleration, Y-axis acceleration, and Z-axis acceleration of test wafer —S601

Controller determines whether X-axis acceleration and Y-axis acceleration of test wafer are both zero — S602

NO

YES

Controller calculates current tilt angle of test wafer based on current three-axis acceleration of test wafer —S603

Controller calculates angle difference between current tilt angle and reference tilt angle of test wafer —S604

Controller determines whether angle difference exceeds angle threshold — S605

NO

YES

Controller triggers alarm signal —S606

FIG. 6

Three-axis acceleration sensor on test wafer
detects current three-axis acceleration of test
wafer, including X-axis acceleration, Y-axis
acceleration, and Z-axis acceleration
of test wafer
S701

Controller
determines whether
any of X-axis acceleration,
Y-axis acceleration, or Z-axis
acceleration of test wafer
exceeds acceleration
threshold
S702

NO

YES

Controller triggers
alarm signal
S703

FIG. 7

Three-axis acceleration sensor on test wafer
detects current three-axis acceleration of
test wafer, including the X-axis acceleration,
Y-axis acceleration, and Z-axis acceleration
of test wafer ~S801

S802

Controller
determines whether
X-axis acceleration and
Y-axis acceleration are
both zero

NO

YES

S803

Controller
determines whether
Z-axis acceleration
exceeds acceleration
threshold

NO

YES

Controller triggers
alarm signal ~S804

FIG. 8

Europäisches
Patentamt

European
Patent Office

Office européen
des brevets

# EUROPEAN SEARCH REPORT

**Application Number**

EP 25 17 3188

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/119169 A1 (AZARYA MOR [IL] ET AL) 20 April 2023 (2023-04-20) | 1-6, 8-14, 16-19 | INV.<br>H01L21/677<br>H01L21/67 |
| A | * abstract; figures 1-5 *<br>* paragraphs [0004] - [0008], [0019] - [0020], [0024] - [0025] * | 7,15 | G01B21/22<br>G01C9/02 |
| Y | US 2007/113652 A1 (RENKEN WAYNE G [US]) 24 May 2007 (2007-05-24) | 1-6, 8-14, 16-19 | |
| A | * abstract; figure 1 *<br>* paragraphs [0053], [0060], [0067] - [0069], [0072] - [0076], [0080] * | 7,15 | |
| X | US 2012/271590 A1 (SAKHARE VIJAY [IN] ET AL) 25 October 2012 (2012-10-25) | 1,3,4,9, 12,13,17 | |
| A | * abstract; figures 1-3, 5-8 *<br>* paragraphs [0059], [0060], [0066] - [0072] * | 7,15 | |
| A | US 2008/228430 A1 (BONCIOLINI DENNIS J [US] ET AL) 18 September 2008 (2008-09-18)<br>* abstract; figures 1-5 *<br>* paragraphs [0005], [0019], [0026], [0030] * | 1-19 | TECHNICAL FIELDS SEARCHED (IPC)<br><br>H01L<br>G01B<br>G01C |
| A | US 2022/206031 A1 (CHOI YOUNG SEOP [KR] ET AL) 30 June 2022 (2022-06-30)<br>* abstract; figures 5-10 *<br>* paragraphs [0091] - [0093], [0152], [0153] * | 1-19 | |
| A | JP 2016 146416 A (SCREEN HOLDINGS CO LTD) 12 August 2016 (2016-08-12)<br>* abstract; figures 3, 5-7 *<br>* paragraphs [0008] - [0011] * | 1-19 | |

The present search report has been drawn up for all claims

| Place of search | Date of completion of the search | Examiner |
|---|---|---|
| The Hague | 26 September 2025 | Faderl, Ingo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 17 3188

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2025

| Patent document cited in search report | Publication date | Patent family member(s) | Publication date |
|---|---|---|---|
| US 2023119169 A1 | 20-04-2023 | CN 107690604 A | 13-02-2018 |
| | | CN 113741376 A | 03-12-2021 |
| | | IL 255850 A | 31-01-2018 |
| | | JP 6952608 B2 | 20-10-2021 |
| | | JP 2018526814 A | 13-09-2018 |
| | | KR 20180009059 A | 25-01-2018 |
| | | SG 10201912239Q A | 27-02-2020 |
| | | TW 201711089 A | 16-03-2017 |
| | | TW 202141577 A | 01-11-2021 |
| | | TW 202336829 A | 16-09-2023 |
| | | US 2016370797 A1 | 22-12-2016 |
| | | US 2023119169 A1 | 20-04-2023 |
| | | WO 2016205075 A1 | 22-12-2016 |
| US 2007113652 A1 | 24-05-2007 | NONE | |
| US 2012271590 A1 | 25-10-2012 | CN 101537617 A | 23-09-2009 |
| | | JP 2009061585 A | 26-03-2009 |
| | | KR 20090023314 A | 04-03-2009 |
| | | SG 150489 A1 | 30-03-2009 |
| | | TW 200918264 A | 01-05-2009 |
| | | US 2009062959 A1 | 05-03-2009 |
| | | US 2012271590 A1 | 25-10-2012 |
| | | WO 2009032204 A1 | 12-03-2009 |
| US 2008228430 A1 | 18-09-2008 | NONE | |
| US 2022206031 A1 | 30-06-2022 | CN 114695201 A | 01-07-2022 |
| | | JP 7337140 B2 | 01-09-2023 |
| | | JP 2022105303 A | 13-07-2022 |
| | | KR 20220096733 A | 07-07-2022 |
| | | TW 202240764 A | 16-10-2022 |
| | | US 2022206031 A1 | 30-06-2022 |
| JP 2016146416 A | 12-08-2016 | NONE | |

EPO FORM P0459

For more details about this annex : see Official Journal of the European Patent Office, No. 12/82